# FASCICULE DE BREVET EUROPEEN

(11) **EP 2 682 503 B1**
(45) Date de publication et mention de la délivrance du brevet: **14.12.2016**
(21) Numéro de dépôt: 13305947.7
(22) Date de dépôt: 03.07.2013
(51) Int. Cl.: C30B 23/06, C30B 29/54, C23C 14/12, C23C 14/26, H01L 51/00, H05B 33/00, C23C 14/24

(54) **Dispositif d'évaporation pour appareil de dépôt sous vide et appareil de dépôt sous vide comprenant un tel dispositif d'évaporation**
Verdampfungsvorrichtung für Vakuumbeschichtungsgerät, und eine solche Verdampfungsvorrichtung umfassendes Vakuumbeschichtungsgerät
Evaporation device for a vacuum-deposition apparatus and vacuum-deposition apparatus including such an evaporation device

(30) Priorité: 04.07.2012 FR 1256424
(43) Date de publication de la demande: 08.01.2014
(73) Titulaire: Riber, 95870 Bezons (FR)
(72) Inventeur: Villette, Jérôme, 92350 LE PLESSIS ROBINSON (FR); Guyaux, Jean-Louis, 91380 CHILLY MAZARIN (FR); Esteve, David, 78380 BOUGIVAL (FR)
(74) Mandataire: Jacobacci Coralis Harle

(56) Documents cités:
- EP-A2- 1 382 713
- JP-A- 2008 115 416

## Description

L'invention concerne un dispositif d'évaporation pouvant être utilisé dans un appareil de dépôt sous vide comportant un creuset et un écran thermique disposé à la périphérie du creuset.

Les dispositifs d'évaporation sont utilisés dans l'industrie pour équiper des appareils de dépôt sous vide servant à déposer des couches, parfois très minces, de matériaux sur des substrats de tailles variées.

Il est connu qu'un dispositif d'évaporation pour appareil de dépôt sous vide comporte :
- un creuset destiné à contenir un matériau à évaporer comprenant un fond, un corps, et une ouverture, et
- des moyens de chauffage entourant au moins partiellement le corps du creuset.

Il est également connu qu'un tel dispositif d'évaporation est destiné à être placé à l'intérieur d'une chambre sous vide de l'appareil de dépôt sous vide dans laquelle la pression est inférieure à 10⁻³ mbar.

Dans ces conditions de pression, le chauffage du corps du creuset par les moyens de chauffage se fait essentiellement par rayonnement, le vide régnant à l'intérieur de la chambre sous vide réduisant les échanges de chaleur par convection.

Selon l'art antérieur, l'ensemble du creuset, ainsi que le matériau à évaporer qu'il contient, est porté à une température élevée. Ce chauffage du creuset est donc uniforme et conduit à chauffer aussi bien la partie du matériau à évaporer qui est proche de l'ouverture du creuset que la partie du matériau à évaporer qui se trouve près du fond du creuset.

Les inventeurs ont analysé que lors de l'évaporation du matériau nécessaire pour réaliser le dépôt, un flux de vapeur s'échappe par l'ouverture du creuset en provenance essentiellement de la surface libre du matériau à évaporer proche de l'ouverture du creuset. La pression de vapeur qui définit la capacité à générer ce flux est gouvernée par la température au niveau de cette surface libre.

Par conséquent, la partie du matériau à évaporer qui est proche de l'ouverture du creuset est progressivement consommée durant l'évaporation.

Cependant, la partie du matériau à évaporer située au milieu et au fond du creuset est chauffée pendant une durée plus longue que la partie du matériau à évaporer située près de l'ouverture.

Ainsi, les différentes parties du corps du creuset sont chauffées de manière uniforme et sont soumises à la même température d'évaporation pendant des durées parfois longues. Le matériau sous la surface libre, qui ne contribue pas majoritairement à l'évaporation, expérimente au moins la même température que la surface libre évaporante. L'exposition continue du matériau à ce flux de chaleur favorise la dégradation du matériau à évaporer. En particulier, au terme de l'évaporation, le matériau situé en partie basse du creuset aura expérimenté une température d'évaporation pendant un temps plus long que le matériau placé en partie haute.

Afin de remédier à l'inconvénient précité, l'invention propose un dispositif d'évaporation pour appareil de dépôt sous vide comportant au moins un écran thermique interposé entre le corps du creuset et les moyens de chauffage, l'écran thermique comprenant au moins un premier élément mobile par rapport au creuset et étant conçu de telle sorte que la quantité de chaleur reçue par le corps du creuset en un point considéré de ce corps soit conforme, à un instant donné, à une fonction non constante de la distance entre le point considéré et le fond du creuset, cette fonction étant ajustable à la faveur d'au moins un degré de mobilité du premier élément de l'écran thermique par rapport au creuset.

La présente invention propose donc un dispositif d'évaporation permettant de chauffer de manière non uniforme les différentes parties du corps du creuset et de faire varier dans le temps la quantité de chaleur reçue par ces différentes parties.

L'échauffement des parties du matériau à évaporer contenu dans le creuset qui ne contribuent pas directement au flux de vapeur utile est alors limité et maîtrisé.

En effet, le dispositif d'évaporation selon l'invention permet par exemple de chauffer localement le matériau à évaporer au niveau de sa surface libre proche de l'ouverture du creuset sans exposer le reste du matériau à évaporer à une forte chaleur qui, à terme, pourrait dégrader ses propriétés physico-chimiques.

Ainsi, en intercalant l'écran thermique entre le corps du creuset et les moyens de chauffage, une partie du matériau à évaporer contenu dans le creuset est préservée d'une partie du flux de chaleur rayonnée par les moyens de chauffage en direction du corps du creuset. L'écran thermique ne transmet qu'une partie du flux de chaleur rayonnée au corps du creuset et réfléchit l'autre partie. L'écran thermique fonctionne donc à la manière d'un miroir pour la chaleur rayonnée par les moyens de chauffage.

Cet écran thermique comprend au moins un premier élément mobile par rapport au creuset permettant de découvrir une partie donnée du corps du creuset et de ne chauffer que sa partie haute pour déclencher l'évaporation du matériau à évaporer à partir de sa surface libre, la plus proche de l'ouverture du creuset.

Ainsi, la quantité de chaleur reçue par le corps du creuset en un point proche de l'ouverture, c'est-à-dire situé à une grande distance du fond du creuset, est plus importante que la quantité de chaleur reçue par un point situé à une petite distance du fond du creuset.

De manière générale, le dispositif d'évaporation selon l'invention permet d'avoir, à un instant donné, un profil de température non constant, le long du corps de creuset.

De plus, la mobilité de ce premier élément permet de faire varier avec le temps la durée pendant laquelle une partie du corps du creuset reçoit de la chaleur de la part des moyens de chauffage. On contrôle ainsi la quantité de chaleur reçue au cours du temps. Ceci peut être par exemple mis à profit pour découvrir le corps du creuset au fur et à mesure de l'évaporation et de la baisse du niveau de matériau à évaporer dans le creuset.

Le creuset selon l'invention est particulièrement adapté au cas des matériaux à évaporer organiques, entrant dans la fabrication de diodes électroluminescentes organiques (« *Organic Light-Emitting Diodes »* ou « *OLEDs »* en anglais) pour l'éclairage ou l'affichage (écrans plats, appareils mobiles, *etc*...) et pour la fabrication de cellules photovoltaïques.

En effet, les matériaux organiques destinés à être évaporés à partir d'un creuset se présentent sous forme de poudres, relativement isolantes thermiquement. Ainsi, il est nécessaire de chauffer ces poudres sur des durées parfois longues.

Cependant, les matériaux organiques sont sensibles à la chaleur et se dégradent lorsqu'ils sont chauffées : c'est le phénomène de la *pyrolyse.* La vitesse de cette pyrolyse est fonction de la température atteinte et du temps passé à cette température. Plus la température est élevée, plus grande est la dégradation du matériau. La quantité de matériau dégradé croît également avec la durée du chauffage.

En outre, les matériaux organiques utilisés sont extrêmement coûteux. Il est donc nécessaire d'optimiser leur taux d'utilisation en minimisant leur dégradation thermique.

Ainsi, le dispositif d'évaporation selon l'invention permet une utilisation de matériau à évaporer optimisée, celui-ci n'étant chauffé qu'à une température élevée que lorsqu'il doit être évaporé.

Par ailleurs, d'autres caractéristiques avantageuses et non limitatives du dispositif d'évaporation sont les suivantes :
- le premier élément de l'écran thermique est montée mobile en translation par rapport au creuset ;
- le premier élément de l'écran thermique est montée mobile en rotation par rapport au creuset ;
- l'écran thermique comprend au moins un deuxième élément, le premier élément de l'écran thermique étant mobile par rapport à ce deuxième élément, et le premier élément et le deuxième élément étant agencées pour définir entre eux des jours de dimensions ajustables en fonction de leurs positions relatives l'un par rapport à l'autre ;
- le dispositif d'évaporation comprend des moyens de pilotage adaptés à piloter au moins le premier élément de l'écran thermique pour ajuster le débit de vapeur du matériau à évaporer à travers l'ouverture du creuset.
- le débit de vapeur du matériau à évaporer à travers l'ouverture du creuset est maintenu constant
- le fond du creuset est monté mobile en translation par rapport au corps du creuset ;
- ledit dispositif d'évaporation comprend des moyens de pilotage supplémentaires adaptés à piloter le fond du creuset pour ajuster le débit de vapeur du matériau à évaporer à travers l'ouverture du creuset.

Enfin, l'invention concerne également un appareil de dépôt sous vide comportant un dispositif d'évaporation selon l'invention.

Des modes de réalisation de l'invention seront décrits en détail en référence aux dessins dans lesquels :
- la figure 1 est une vue schématique en coupe d'un appareil de dépôt sous vide équipé d'un dispositif d'évaporation selon un premier mode de réalisation de l'invention ;
- la figure 2 est une vue schématique en coupe d'un dispositif d'évaporation comportant un écran thermique avec un premier élément masquant presque entièrement les moyens de chauffage ;
- la figure 3 est une vue schématique en coupe du dispositif d'évaporation de la figure 2, dans lequel le premier élément a coulissé le long du creuset pour découvrir les moyens de chauffage ;
- la figure 4 est une vue schématique en coupe d'un creuset et d'un écran thermique sur laquelle est représenté la quantité de chaleur reçue par le corps du creuset lorsque le dispositif d'évaporation est dans la configuration de la figure 2 ;
- la figure 5 est une vue schématique en coupe d'un creuset et d'un écran thermique sur laquelle est représenté la quantité de chaleur reçue par le corps du creuset lorsque le dispositif d'évaporation est dans la configuration de la figure 3 ;
- la figure 6 est une vue schématique en coupe d'un appareil de dépôt sous vide équipé d'un dispositif d'évaporation selon un deuxième mode de réalisation de l'invention ;
- la figure 7 est une vue en perspective d'un premier élément d'écran thermique présentant des jours en forme de fentes verticales selon un second mode de réalisation ;
- la figure 8 est une vue en perspective d'un deuxième élément d'écran thermique présentant des jours en forme de trapèzes selon le second mode de réalisation ;
- la figure 9 est une vue en perspective de l'écran thermique selon le second mode de réalisation comprenant le premier élément de la figure 7 et le deuxième élément de la figure 8 ;
- la figure 10 représente la vue dépliée à plat de l'écran thermique de la figure 9 sur laquelle on a représenté la quantité de chaleur reçue par le corps du creuset lorsque les jours du premier élément et du deuxième élément sont en regard dans leur partie haute ;
- la figure 11 représente la vue dépliée à plat de l'écran thermique de la figure 9 sur laquelle on a représenté la quantité de chaleur reçue par le corps du creuset lorsque les jours du premier élément et du deuxième élément sont en regard sur environ la moitié de leur hauteur ;
- les figures 12 et 13 sont des vues schématiques en coupe d'un appareil de dépôt sous vide équipé d'un dispositif d'évaporation selon un troisième mode de réalisation de l'invention pour deux configurations différentes de l'écran thermique.

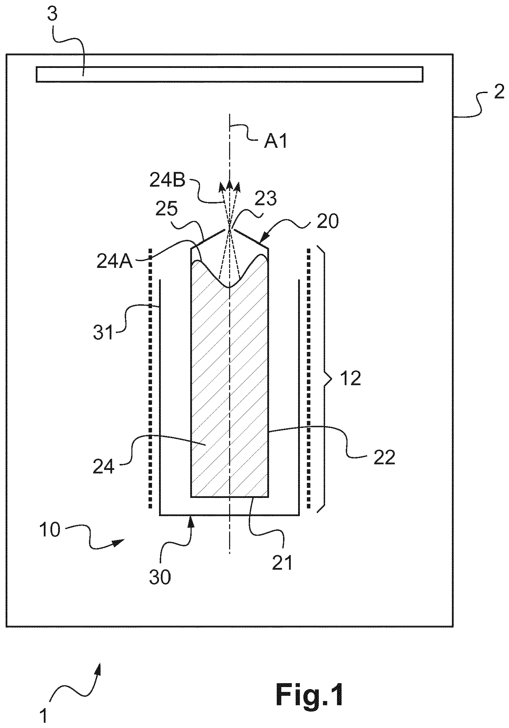

La figure 1 représente une vue schématique en coupe d'un appareil de dépôt sous vide 1 comportant un dispositif d'évaporation 10 selon un premier mode de réalisation de l'invention.

L'appareil de dépôt sous vide 1 comporte tout d'abord une chambre sous vide 2 comportant un substrat 3 dans sa partie supérieure.

Pour un tel appareil de dépôt sous vide 1, les conditions de pression dans la chambre sous vide 2 sont telles que, en fonctionnement, la pression à l'intérieur de celle-ci est inférieure à 10⁻³ millibar (mbar), et de préférence inférieure à 10⁻⁵ mbar. Ceci permet notamment de déposer des couches sur le substrat avec une bonne qualité de dépôt.

Comme représenté sur la figure 1, l'appareil de dépôt sous vide 1 comporte également un dispositif d'évaporation 10 placé à l'intérieur de la chambre sous vide 2, généralement dans sa partie basse, c'est-à-dire en dessous du substrat 3.

Le dispositif d'évaporation 10 comporte tout d'abord un creuset 20 présentant une forme sensiblement cylindrique, de révolution autour de l'axe de révolution A1. Ce creuset 20 est délimité, d'une part, par un fond 21 dans sa partie inférieure, et, d'autre part, par un corps 22 dans sa partie latérale.

Le creuset 20 comprend dans sa partie supérieure un col 25 de forme tronconique s'étendant depuis le corps 22 du creuset 20 jusqu'à une ouverture 23 centrée sur l'axe de révolution A1 de sorte que l'ouverture 23 soit orientée vers le substrat 3.

Le creuset 20 contient un matériau à évaporer 24 présentant une surface libre 24A tournée vers l'ouverture 23.

Le dispositif d'évaporation 10 comporte également des moyens de chauffage 12 disposés à la périphérie du creuset 20 pour entourer au moins partiellement le corps 22 du creuset 20. Les moyens de chauffage 12 s'étendent ici verticalement depuis le col 25 du creuset 20, parallèlement au corps 22 du creuset 20, et descendent jusqu'à un niveau situé en dessous du fond 21 du creuset 20.

Les moyens de chauffage 12 comprennent ici des résistances électriques qui sont portées à haute température pour transmettre de la chaleur au corps 22 du creuset 20 qui leur fait face.

Les conditions de pression à l'intérieur de la chambre sous vide 2 sont telles que les échanges de chaleur entre les moyens de chauffage 12 et le corps 22 du creuset 20 se font essentiellement par rayonnement, car les échanges par convection sont fortement limités du fait du vide régnant dans la chambre sous vide 2.

Le dispositif d'évaporation 10 comporte également un écran thermique 30 situé à l'intérieur de la chambre sous vide 2 et interposé entre le corps 22 du creuset 20 et les moyens de chauffage 12.

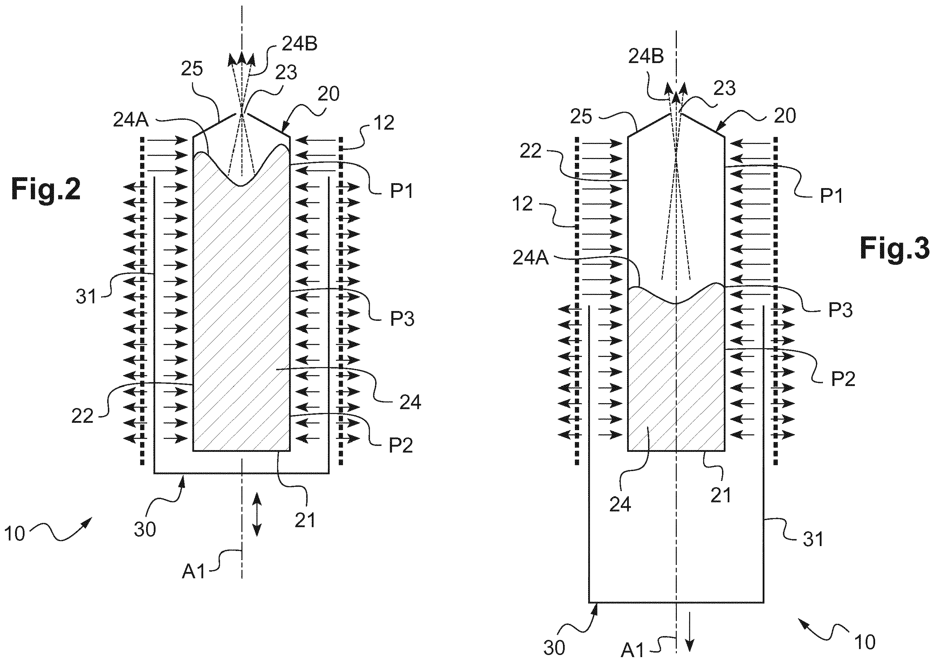

Dans un premier mode de réalisation de l'invention illustré sur les figures 2 à 5, cet écran thermique 30 comprend ici un unique premier élément 31 de forme cylindrique, son diamètre étant supérieur au diamètre du corps 22 du creuset 20 pour l'entourer au moins partiellement mais suffisamment petit pour que le premier élément 31 s'intercale entre les résistances électriques 12 et le corps 22 du creuset 20.

Le premier élément 31 de l'écran thermique 30 est ici constitué d'un cylindre creux en quartz dont la paroi extérieure est revêtue d'une couche réfléchissant le rayonnement thermique émis par les moyens de chauffage 12. Cette couche peut être une couche métallique, par exemple une couche d'argent, d'aluminium, ou bien d'or. Ainsi constitué, le premier élément 31 de l'écran thermique 30 fonctionne à la manière d'un miroir qui réfléchit une partie du rayonnement thermique émis par les moyens de chauffage 12 et incident sur sa surface externe.

En variante, le premier élément pourrait être constitué d'un cylindre en verre ou en silice fondue revêtue d'une couche réfléchissante dans l'infrarouge. En variante encore, le premier élément pourrait être constitué d'un cylindre métallique.

Dans le mode de réalisation particulier du dispositif d'évaporation 10, représenté sur les figures 2 à 5, la partie mobile 31 de l'écran thermique 30 est montée mobile en translation par rapport au creuset 20 de telle sorte qu'il puisse coulisser le long du corps 22 du creuset 20 entre :
- une position haute dans laquelle l'écran thermique 30 couvre entièrement le corps 22 du creuset 20, c'est-à-dire dans laquelle l'écran thermique 30 masque le corps 22 du creuset 20 à toutes les résistances chauffantes 12, et
- une position basse dans laquelle l'écran thermique 30 découvre entièrement le corps 22 du creuset 20, c'est-à-dire dans laquelle les résistances chauffantes 12 sont en vis-à-vis avec le corps 22 de creuset 20, l'écran thermique 30 étant alors escamoté.

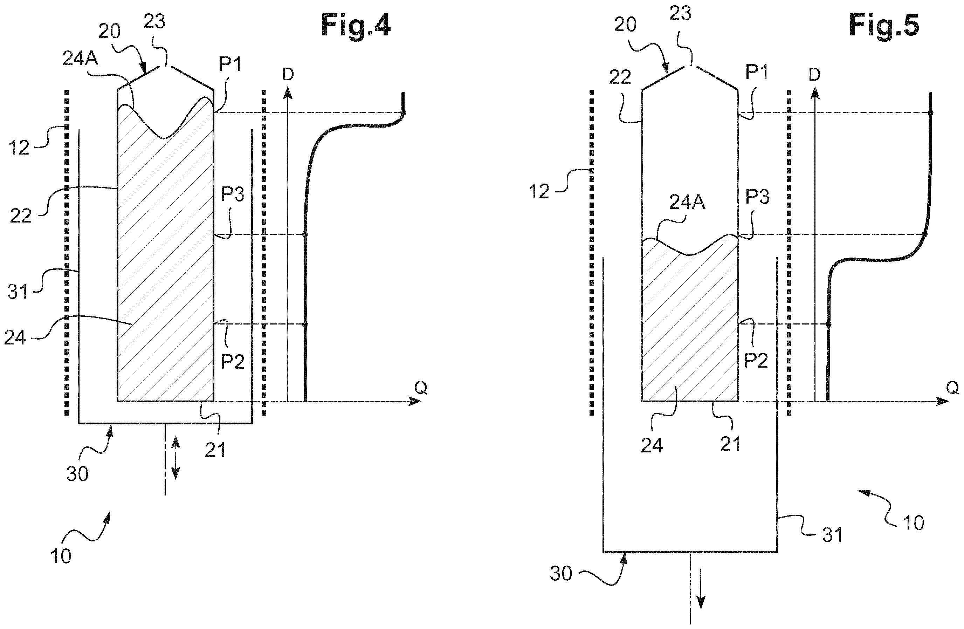

Les figures 2 à 5 représentent l'écran thermique 30 dans des positions intermédiaires entre la position haute et la position basse. Les figures 2 et 4 correspondent à un configuration où le premier élément 31 de l'écran thermique 30 a coulissé légèrement le long du corps 22 de creuset 20, descendant depuis la position haute pour découvrir la partie supérieure des moyens de chauffage 12. Les figures 3 et 5 correspondent à une configuration où le premier élément 31 de l'écran thermique 30 a coulissé encore plus le long du corps 22 de creuset 20, descendant depuis la position des figures 2 et 4.

Ainsi, suivant la position de la partie mobile 31 de l'écran thermique 30 par rapport au creuset 30, on peut distinguer deux cas de figure différents en fonction du point considéré sur le corps 22 du creuset 20 :
i) Cas du point P1 : le point P1 est en regard direct avec les moyens de chauffage 12 si bien que la quantité de chaleur Q reçue par le corps 22 du creuset 20 au point P1 considéré est élevée ;
ii) Cas du point P2 : le point P2 est masqué des moyens de chauffage 12 par l'écran thermique 30 et en particulier par son premier élément 31, si bien que la quantité de chaleur Q reçue par le corps 22 du creuset 20 au point P2 considéré est faible.

On peut également voir cela sur les figures 4 et 5 sur lesquelles on a représenté la quantité de chaleur Q reçue par le corps 22 du creuset 20 en fonction de la distance D entre le point considéré et le fond 21 du creuset 20, pour les deux positions intermédiaires du premier élément 31 de l'écran thermique 30 par rapport au creuset 20.

On constate donc sur les figures 4 et 5 que la quantité de chaleur Q reçue par le corps 22 du creuset 20 en un point considéré de ce corps 22 est conforme, à un instant donné, à une fonction non constante de la distance D entre le point considéré et le fond 21 du creuset 20, cette fonction ayant ici une forme en créneau.

Par ailleurs, considérons désormais le point P3, tel que repéré sur les figures 2 à 5. Dans le cas des figures 2 et 4, le premier élément 31 de l'écran thermique 30 est dans une position telle par rapport au corps 22 du creuset 20 que le point P3 considéré du corps 22 de creuset 20 est couvert par le premier élément 31 de l'écran thermique 30, masquant les moyens de chauffage 12. Aussi, comme illustré sur la figure 3, la quantité de chaleur Q reçue par le corps 22 de creuset 20 au point P3 est faible.

De la même manière, dans le cas des figures 3 et 5, le premier élément 31 de l'écran thermique 30, ayant coulissé un peu plus vers le bas le long du corps 22 du creuset 20, est dans une position telle par rapport au corps 22 du creuset 20 que le point P3 considéré du corps 22 de creuset 20 est découvert par le premier élément 31 de l'écran thermique 30, les moyens de chauffage 12 étant alors en regard direct avec le point P3. Ainsi, comme illustré sur la figure 4, la quantité de chaleur Q reçue par le corps 22 de creuset 20 au point P3 est élevée.

On comprend donc que la quantité de chaleur Q reçue par le corps 22 de creuset 20 est ajustable à la faveur du mouvement, ici du coulissement, du premier élément 31 de l'écran thermique 30 par rapport au creuset 20.

Considérons maintenant le matériau à évaporer 24 contenu dans le creuset 20 et en particulier sa surface libre 24A tournée vers l'ouverture 23 du creuset 20.

Dans la configuration des figures 2 et 4, la surface libre 24A est au même niveau que le point P1, c'est-à-dire à une grande distance D du fond 21 du creuset 20, et le corps 22 de creuset 20 reçoit à ce niveau une quantité de chaleur Q élevée de la part des moyens de chauffage 12, le premier élément 31 de l'écran thermique 30 ne masquant pas ces derniers.

En revanche, pour les parties du matériau à évaporer 24 situées à une distance D plus petite du fond 21 du creuset 20 que la surface libre 24A, la quantité de chaleur Q reçue par le corps 22 du creuset 20 est plus faible, celle-ci étant non uniforme en fonction de la distance D au fond 21 du creuset 20, comme cela est visible sur la figure 3.

Ainsi, la surface libre 24A du matériau à évaporer 24 est fortement chauffée, alors que les parties du matériau à évaporer 24 situées plus près du fond 21 du creuset 20 sont faiblement chauffées.

Par conséquent, la température du matériau à évaporer 24 est suffisamment augmentée au niveau de sa surface libre 24A pour qu'un flux de vapeur 24B soit généré à partir de cette surface libre 24A et s'échappe à travers l'ouverture 23 du creuset 20.

De la même manière, la température du matériau à évaporer 24 au milieu ou au fond du creuset 20 est augmentée mais l'élévation de température est limitée, car la quantité de chaleur Q reçue par le corps 22 de creuset 20 au niveau de ces parties est assez faible pour que la température atteinte n'entraîne pas la dégradation du matériau à évaporer 24.

Un flux de vapeur 24B étant généré à partir de la surface libre 24A, le matériau à évaporer 24 contenu dans le creuset 20 est consommé par évaporation de sorte que le niveau de la surface libre 24A descend dans le corps 22 du creuset 20.

Ceci peut être illustré par les figures 3 et 5, où le niveau de la surface libre 24A a baissé pour se rapprocher du fond 21 du creuset 20. De même, comme décrit précédemment, le premier élément 31 de l'écran thermique 30 a coulissé vers le bas le long du corps 22 du creuset 20 depuis sa position initiale, représentée sur les figures 2 et 4.

La surface libre 24A est désormais au même niveau que le point P3 sur le corps 22 de creuset 20 et le corps 22 de creuset 20 reçoit à ce niveau une quantité de chaleur Q élevée de la part des moyens de chauffage 12, le premier élément 31 de l'écran thermique 30 ne masquant pas ces derniers.

On remarque en effet sur la figure 4 que la quantité de chaleur Q reçue par le corps 22 du creuset 20 présente un profil non uniforme en fonction de la distance D au fond 21 du creuset 20, ce profil ayant varié par rapport au profil représenté sur la figure 3 suite au mouvement de translation du premier élément 31 de l'écran thermique 30 parallèlement à l'axe de révolution A1.

Ainsi, comme expliqué précédemment, la température du matériau à évaporer 24 est suffisamment augmentée au niveau de sa surface libre 24A pour qu'un flux de vapeur 24B soit généré et se dirige vers l'ouverture 23 du creuset 20.

On comprend donc qu'il est possible avec le dispositif d'évaporation 10 décrit ci-dessus, d'ajuster la quantité de chaleur Q reçue par le corps 22 du creuset 20 grâce au mouvement du premier élément 31 de l'écran thermique 30 par rapport au creuset 20.

Il est en particulier possible de contrôler la position du le premier élément 31 de l'écran thermique 30 par rapport au creuset 20 au cours du temps, et au fur et à mesure que le niveau du matériau à évaporer 24 baisse dans le creuset 20, de manière à adapter le profil de la quantité de chaleur Q reçue par le corps 22 du creuset 20 à la répartition du matériau à évaporer 24 dans le creuset.

De cette manière, la surface libre 24A peut être suffisamment chauffée tout au long de l'évaporation du matériau à évaporer 24 afin de maintenir le flux de vapeur 24B à travers l'ouverture 23 du creuset 20.

Avantageusement, dans un autre mode de réalisation du dispositif d'évaporation, il est ainsi prévu des moyens de pilotage pilotant au moins le premier élément de l'écran thermique pour ajuster le débit de vapeur du matériau à évaporer à travers l'ouverture du creuset. Ces moyens de pilotage permettent par exemple d'actionner la partie mobile de l'écran thermique pour la faire coulisser le long du corps du creuset, de sorte que le débit de vapeur du matériau à évaporer à travers l'ouverture du creuset soit constant.

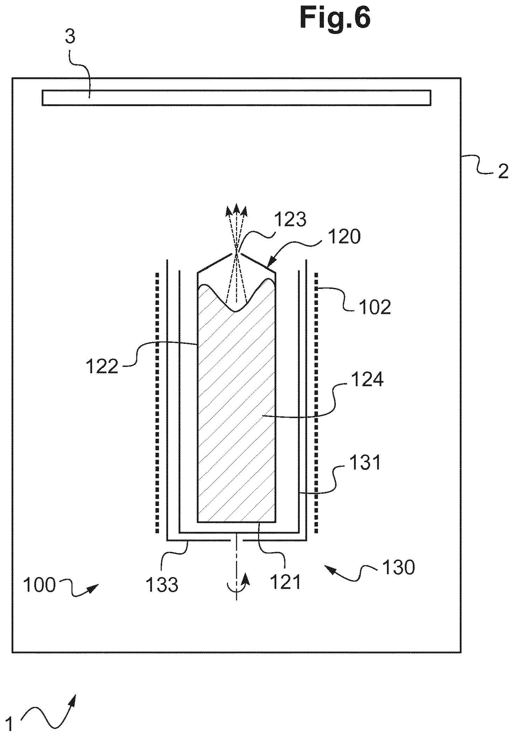

Les figures 6 à 10 sont relatives à un second mode de réalisation de l'invention.

On a ainsi représenté sur la figure 6 l'appareil de dépôt sous vide 1 avec la chambre sous vide 2 et le substrat 3.

Dans ce second mode de réalisation, un dispositif d'évaporation 100 est placé à l'intérieur de la chambre sous vide 2 de l'appareil de dépôt sous vide 1. Le dispositif d'évaporation 100, comporte :
- un creuset 120, identique au premier mode de réalisation, contenant un matériau à évaporer 124 et comprenant un fond 121, un corps 122, et une ouverture 123, et
- des moyens de chauffage 102, identiques au premier mode de réalisation, entourant au moins partiellement le corps 122 du creuset 120.

Le dispositif d'évaporation 100 comporte en outre un écran thermique 130 comprenant :
- un premier élément 131 mobile par rapport au creuset 120, et
- un deuxième élément 133 par rapport auquel le premier élément 131 est également mobile.

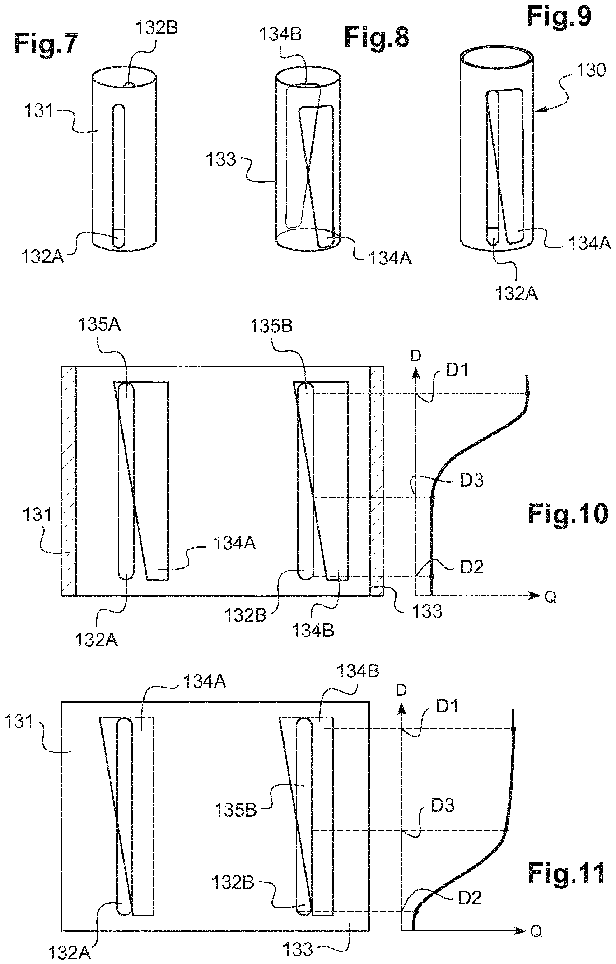

Les figures 7 à 9 détaillent les caractéristiques de l'écran thermique 130, ainsi que des premier et deuxième éléments 131, 133.

On a ainsi représenté sur la figure 7 le premier élément 131 qui a la forme d'un cylindre de révolution, ici constitué d'une tôle métallique.

En variante, le premier élément pourrait être par exemple formé d'un cylindre de révolution en quartz comprenant un dépôt métallique ou tout autre matériau pouvant jouer le rôle d'un écran thermique.

Le premier élément 131 comprend deux premières ouvertures 132A, 132B identiques qui sont ici diamétralement opposées. Les premières ouvertures 132A, 132B se présentent sous la forme de fentes verticales s'étendant entre la partie basse et la partie haute du premier élément 131. Ainsi formées, la surface totale des premières ouvertures 132A, 132B correspond à environ 50% de la surface du premier élément 131.

De la même manière, on a représenté sur la figure 8 un deuxième élément 133 qui a la forme d'un cylindre de révolution, également constitué d'une tôle métallique.

En variante encore, le deuxième élément pourrait être par exemple formé d'un cylindre de révolution en quartz comprenant un dépôt métallique ou tout autre matériau pouvant jouer le rôle d'un écran thermique.

Ce deuxième élément 133 comprend également deux deuxièmes ouvertures 134A, 134B identiques qui sont diamétralement opposées. Ces deuxièmes ouvertures 134A, 134B ont une forme trapézoïdale et s'étendent entre la partie basse et la partie haute du deuxième élément 132, les deuxièmes ouvertures 134A, 134B étant plus larges dans la partie haute que dans la partie basse.

La hauteur des deuxièmes ouvertures 134A, 134B est ici sensiblement égale à la hauteur des premières ouvertures 132A, 132B. De même, les premières ouvertures 132A, 132B ont une largeur sensiblement égale à la largeur des deuxièmes ouvertures 134A, 134B prises en leur base.

La figure 9 représente l'écran thermique 130 de ce second mode de réalisation, comportant le premier élément 131 de la figure 7 et le deuxième élément 133 de la figure 8.

En particulier, le diamètre du deuxième élément 133 est ici supérieur au diamètre du premier élément 131 de sorte que le deuxième élément 133 entoure entièrement le premier élément 131. Comme représenté sur la figure 6, le premier élément 131 est disposé à la périphérie du creuset 120, face au corps 122 du creuset 120, pour le couvrir entièrement. De plus, le deuxième élément 133 est intercalé entre le premier élément 131 et les moyens de chauffage 102 du dispositif d'évaporation 100.

Ainsi constitué, l'écran thermique 130 s'interpose entre le corps 122 du creuset 120 et les moyens de chauffage 102.

Alternativement, le diamètre du deuxième élément peut être inférieur au diamètre du premier élément de sorte que le premier élément entoure entièrement le deuxième élément.

Dans ce deuxième mode de réalisation, le premier élément 131 mobile par rapport au creuset 120 est également mobile, ici en rotation, par rapport au deuxième élément 133.

En fonction de la position des premières ouvertures 132A, 132B par rapport à la position des deuxièmes ouvertures 134A, 134B, celles-ci se trouvent partiellement ou totalement en regard les unes des autres.

Ainsi, le premier élément 131 et le deuxième élément 132 définissent entre eux des jours de dimensions ajustables en fonction de leurs positions relatives.

Par rotation du premier élément 131 par rapport au deuxième élément 133, il est en effet possible d'amener les premières ouvertures 132A, 132B en regard des deuxièmes ouvertures 134A, 134B.

Les premières ouvertures 132A, 132B, d'une part, et les deuxièmes ouvertures 134A, 134B, d'autre part, étant ici diamétralement opposées, on comprend que, par exemple, lorsque la première ouverture 132A est en regard de la deuxième ouverture 134A, alors la première ouverture 132B est en regard de la deuxième ouverture 134B.

De plus, la forme des deuxièmes ouvertures 134A, 134B étant trapézoïdale, la hauteur des jours formés par l'agencement du premier élément 131 par rapport au deuxième élément 133 varie également en fonction de leurs positions relatives et peut être ajustée par rotation du premier élément 131 par rapport au deuxième élément 133.

On comprendra qu'un écran thermique 130 présentant des jours et interposé entre les moyens de chauffage 102 et le corps 122 du creuset 120 du dispositif d'évaporation 100 transmet quasi intégralement la chaleur rayonnée par les moyens de chauffage 102 en direction du corps 122 du creuset 120.

Ceci est illustré sur les figures 10 et 11 sur lesquelles on a représenté :
- à gauche de la figure, une vue dépliée et à plat de l'écran thermique 130, faisant apparaître la superposition du premier élément 131 avec le deuxième élément 133, et
- à droite de la figure, la quantité de chaleur Q reçue en un point considéré du corps 122 du creuset 120 en fonction de la distance D de ce point et le fond 121 du creuset 120.

La figure 10 correspond à un cas où les premières ouvertures 132A, 132B du premier élément 131 sont partiellement en regard avec les deuxièmes ouvertures 134A, 134B du deuxième élément 133 de l'écran thermique 130 de la figure 9.

Dans la configuration de la figure 10, on observe que les jours 135A, 135B définis par l'agencement du premier élément 131 par rapport au deuxième élément 133 ont une forme quasi trapézoïdale, et une hauteur sensiblement égale à la moitié de la hauteur des premières ouvertures 132A, 132B.

Comme représenté sur la courbe de droite de la figure 10, on comprend donc que la quantité de chaleur Q reçue à une distance D1 du fond 121 du creuset 120 est élevé, alors que la quantité de chaleur Q reçue à une distance D3 du fond 121 du creuset 120 est faible et que la quantité de chaleur Q reçue à une distance D2 du fond 121 du creuset 120 est très faible, aucun jour n'existant pour cette distance D2.

Ainsi, on constate que la quantité de chaleur Q reçue par le corps 122 du creuset 120 en un point considéré de ce corps 122 est conforme, à un instant donné, à une fonction non constante de la distance D entre ce point considéré et le fond 121 du creuset 120.

À partir de la situation décrite sur la figure 10, on fait varier par rotation du premier élément 131 les positions relatives du premier élément 131 et du deuxième élément 133 pour amener les premières ouvertures 132A, 132B quasiment totalement en regard des deuxièmes ouvertures 134A, 134B. On obtient alors la situation décrite sur la figure 11.

Dans cette configuration, on observe alors que les dimensions des jours 135A, 135B définis entre le premier élément 131 et le deuxième élément 133 ont changées, ceux-ci étant désormais plus grands que ceux de la situation précédente de la figure 10, s'étendant presque sur toute la hauteur des premières ouvertures 132A, 132B.

Comme représenté sur la courbe de droite de la figure 11, on comprend donc que non seulement la quantité de chaleur Q reçue à une distance D1 du fond 121 du creuset 120 mais aussi la quantité de chaleur Q reçue à une distance D3 du fond 121 du creuset 120 sont élevées. En revanche, la quantité de chaleur Q reçue à une distance D2 du fond 121 du creuset 120 est toujours comparativement plus faible, aucun jour n'existant pour cette distance D2.

Ainsi, on constate que la quantité de chaleur Q reçue par le corps 122 du creuset 120 en un point considéré de ce corps 122 est ajustable grâce à la rotation du premier élément 131 de l'écran thermique 130 par rapport au creuset 120.

Avantageusement, il peut être envisagé également que l'écran thermique 130 dans son ensemble, c'est-à-dire le premier élément 131 et le deuxième élément 133, soit en rotation par rapport au creuset 120 de sorte que le matériau à évaporer 124 contenu dans le creuset 120 soit chauffé de manière uniforme sur toute la périphérie du creuset 120.

En variante, les premier et deuxième éléments pourraient comporter une pluralité d'ouvertures, dont la forme et la position pourraient être adaptées au profil de température souhaité sur le corps du creuset.

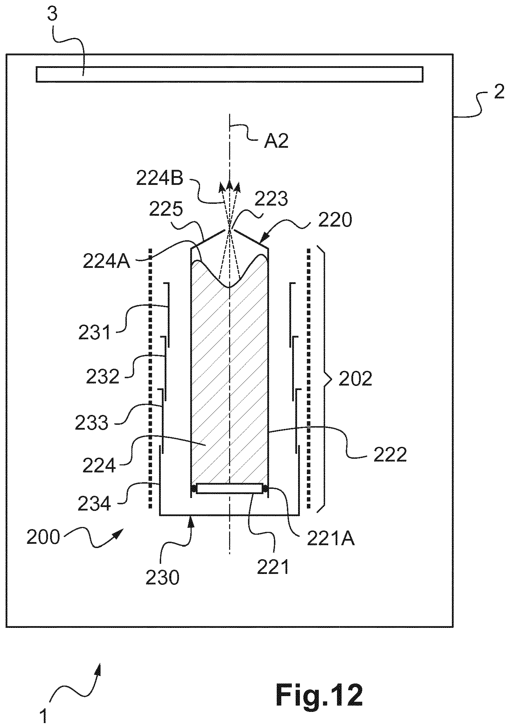

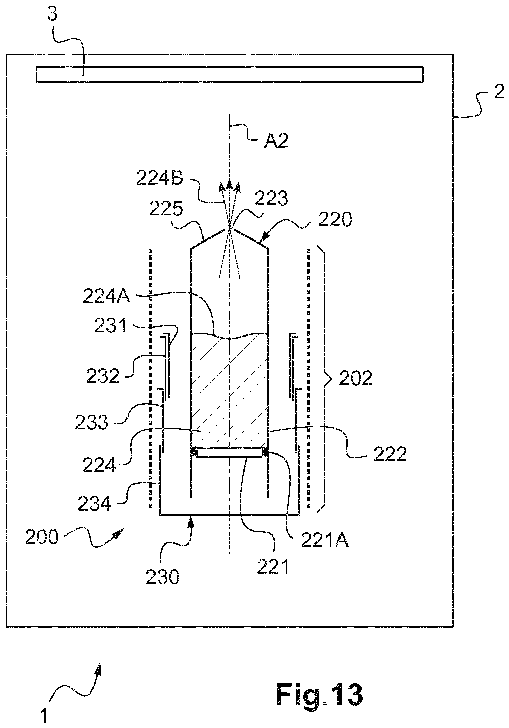

Les figures 12 et 13 sont relatives à un troisième mode de réalisation de l'invention.

On a ainsi représenté sur les figures 12 et 13 l'appareil de dépôt sous vide 1 avec la chambre sous vide 2 et le substrat 3.

Dans ce troisième mode de réalisation, un dispositif d'évaporation 200 est placé à l'intérieur de la chambre sous vide 2 de l'appareil de dépôt sous vide 1. Le dispositif d'évaporation 200, comporte (voir par exemple figure 12) un creuset 220, identique au premier mode de réalisation, contenant un matériau à évaporer 224 et comprenant un fond 221, corps 222, et une ouverture 223.

De manière préférée, le fond 221 du creuset 220 est ici monté mobile en translation par rapport au creuset 220 suivant une direction longitudinale du creuset 220, c'est-à-dire la direction de l'axe A2. Un joint torique 221A, par exemple en caoutchouc, disposé à la périphérie du fond 221 mobile, assure l'étanchéité entre le fond 221 et le corps 222 du creuset 220.

Dans cette configuration, le dispositif d'évaporation 200 comprend également des moyens de pilotage supplémentaires (non représentés) qui pilotent la translation du fond 221 du creuset 220.

En d'autres termes, ces moyens de pilotage actionnent le fond 221 du creuset 220 pour le déplacer le long du corps 222 du creuset.

De tels moyens de pilotage peuvent comporter par exemple une tige d'actionnement reliée, d'un côté, à un moteur et de l'autre côté, au fond 221 du creuset 220, le mouvement de translation de la tige d'actionnement étant alors transmis au fond 221 du creuset 220.

Grâce au joint torique 221A, le fond 221 du creuset 220 peut ainsi coulisser de manière étanche le long du corps 222 du creuset 220.

Le dispositif d'évaporation 200 comporte également des moyens de chauffage 202, identiques à ceux du premier mode de réalisation, entourant au moins partiellement le corps 222 du creuset 220.

Le dispositif d'évaporation 200 comporte en outre un écran thermique 230 comprenant ici (voir figures 12 et 13) :
- un premier élément 231 mobile par rapport au creuset 220, et
- un deuxième élément 232, un troisième élément 233, et un quatrième élément 234 par rapport auxquels le premier élément 231 est également mobile.

Comme représenté sur les figures 12 et 13, cet écran thermique 230 est de type « *télescopique »* avec des première, deuxième, troisième et quatrième éléments 231, 232, 233, 234 dont le diamètre extérieur est ajusté de sorte que le premier élément 231 s'emboîte dans le deuxième élément 232, que le deuxième élément 232 s'emboîte dans le troisième élément 233 s'emboîte dans le quatrième élément 234.

De cette façon, la hauteur de l'écran thermique 230, c'est-à-dire sa dimension selon l'axe de révolution A1 (voir figures 12 et 13), peut être réglée de manière grossière.

Ainsi, la figure 12 fait apparaître l'écran thermique 230 selon sa plus grande hauteur, lorsque tous les éléments 231, 232, 233, 234 sont dépliés. La figure 13, quant à elle, fait apparaître l'écran thermique 230 lorsque le premier élément 231 est descendu, emboîté dans le deuxième élément 232, découvrant ainsi les moyens de chauffage 202 du dispositif d'évaporation 200.

On comprend donc que la quantité de chaleur Q reçue par le corps 222 du creuset 220 en un point considéré de ce corps 222 est conforme, à un instant donné, à une fonction non constante de la distance D entre le point considéré et le fond 221 du creuset 220, cette fonction étant ajustable à la faveur du déplacement du premier élément 231 de l'écran thermique 230 par rapport au creuset 220.

Le matériau à évaporer 224 étant soumis au rayonnement des moyens de chauffage 202, un flux de vapeur 224B s'établit au travers de l'ouverture 223 du creuset 220 de sorte que la surface libre 224A du matériau à évaporer 224 s'abaisse dans le creuset 220 (voir figure 13) jusqu'à un niveau situé ici en regard du premier élément 231.

Grâce aux moyens de pilotage supplémentaires qui actionnent le fond 221 du creuset 220, il est possible de régler avec précision la position de la surface libre 224A dans le corps 222 du creuset 220 et ainsi la quantité de chaleur reçue par le matériau à évaporer 224, en particulier au niveau de sa surface libre 224A.

De cette manière, le débit de vapeur du matériau à évaporer 224 au travers l'ouverture 223 du creuset 220 peut être ajusté finement, grâce au déplacement du fond 221 du creuset 220.

On notera néanmoins que même si le troisième mode de réalisation du dispositif d'évaporation 200 représenté sur les figures 12 et 13 combine un écran thermique 230 de type télescopique avec un creuset 220 dont le fond 221 est mobile, ceux-ci peuvent être utilisés séparément l'un de l'autre au sein d'un autre dispositif d'évaporation conforme à l'invention.

## Revendications

1. Dispositif d'évaporation (10) pour appareil de dépôt sous vide (1) comportant :
- un creuset (20) destiné à contenir un matériau à évaporer (24) et comprenant un fond (21), un corps (22), et une ouverture (23), et
- des moyens de chauffage (12) entourant au moins partiellement le corps (22) du creuset (20),
le dispositif d'évaporation (10) étant destiné à être placé à l'intérieur d'une chambre sous vide (2) de l'appareil de dépôt sous vide (1) dans laquelle la pression est inférieure à 10⁻³ mbar, et étant **caractérisé en ce qu'**il comporte également au moins un écran thermique (30) interposé entre le corps (22) du creuset (20) et les moyens de chauffage (12), l'écran thermique (30) comprenant au moins un premier élément (31) mobile par rapport au creuset (20) et étant conçu de telle sorte que la quantité de chaleur (Q) reçue par le corps (22) du creuset (20) en un point considéré (P1, P2, P3) de ce corps (22) soit conforme, à un instant donné, à une fonction non constante de la distance (D) entre le point considéré (P1, P2, P3) et le fond (21) du creuset (20), cette fonction étant ajustable à la faveur d'au moins un degré de mobilité du premier élément (31) de l'écran thermique (30) par rapport au creuset (20).

2. Dispositif d'évaporation (10) selon la revendication 1, dans lequel le premier élément (31) de l'écran thermique (30) est monté mobile en translation par rapport au creuset (20).

3. Dispositif d'évaporation (10) selon l'une des revendications 1 et 2, dans lequel le premier élément (31) de l'écran thermique (30) est monté mobile en rotation par rapport au creuset (20)

4. Dispositif d'évaporation (100) selon l'une des revendications 1 à 3, dans lequel l'écran thermique (130) comprend au moins un deuxième élément (133), le premier élément (131) de l'écran thermique (130) étant mobile par rapport à ce deuxième élément (133), et le premier élément (131) et le deuxième élément (133) étant agencées pour définir entre eux des jours (135A, 135B) de dimensions ajustables en fonction de leurs positions relatives.

5. Dispositif d'évaporation (10 ; 100) selon l'une des revendications 1 à 4, comprenant des moyens de pilotage adaptés à actionner une partie mobile (31 ; 131) de l'écran thermique (30 ; 130) par rapport au corps (22 ; 122) du creuset (20 ; 120).

6. Dispositif d'évaporation (200) selon l'une des revendications 1 à 5, dans lequel le fond (221) du creuset (220) est monté mobile en translation par rapport au corps (222) du creuset (220).

7. Dispositif d'évaporation (200) selon la revendication 6, comprenant des moyens de pilotage supplémentaires adaptés à actionner le fond (221) du creuset (220) pour déplacer ledit fond (221) le long du corps (222) du creuset (220).

8. Appareil de dépôt sous vide (1) comportant un dispositif d'évaporation (10 ; 100 ; 200) selon l'une des revendications 1 à 7.

## Patentansprüche

1. Verdampfungsvorrichtung (10) für ein Vakuumbeschichtungsgerät (1), die
- einen Tiegel (20), der dazu bestimmt ist, ein zu verdampfendes Material (24) zu enthalten, und der einen Boden (21), einen Körper (22) und eine Öffnung (23) aufweist, und
- den Körper (22) des Tiegels (20) wenigstens teilweise umgebende Heizmittel (12)
aufweist,
wobei die Verdampfungsvorrichtung (10) dazu bestimmt ist, im Inneren einer Vakuumkammer (2) des Vakuumbeschichtungsgeräts (1) angeordnet zu sein, in der ein Druck von weniger als 10⁻³ mbar herrscht, und
**dadurch gekennzeichnet ist, daß** sie außerdem wenigstens einen zwischen dem Körper (22) des Tiegels (20) und den Heizmitteln (12) angeordneten Wärmeschild (30) aufweist, wobei der Wärmeschild (30) wenigstens ein in Bezug auf den Tiegel (20) bewegliches erstes Element (31) aufweist und so ausgelegt ist, daß die vom Körper (22) des Tiegels (20) an einem bestimmten Punkt (P1, P2, P3) des Körpers (22) aufgenommene Wärmemenge (Q) zu einem bestimmten Zeitpunkt einer nicht konstanten Funktion des Abstands (D) zwischen dem bestimmten Punkt (P1, P2, P3) und dem Boden (21) des Tiegels (20) entspricht, wobei diese Funktion in Abhängigkeit von wenigstens einem Freiheitsgrad des ersten Elements (31) des Wärmeschilds (30) in Bezug auf den Tiegel (20) einstellbar ist.

2. Verdampfungsvorrichtung (10) gemäß Anspruch 1, bei der das erste Element (31) des Wärmeschilds (30) in Bezug auf den Tiegel (20) translatorisch beweglich angebracht ist.

3. Verdampfungsvorrichtung (10) gemäß einem der Ansprüche 1 und 2, bei der das erste Element (31) des Wärmeschilds (30) in Bezug auf den Tiegel (20) drehbeweglich angebracht ist.

4. Verdampfungsvorrichtung (100) gemäß einem der Ansprüche 1 bis 3, bei der der Wärmeschild (130) wenigstens ein zweites Element (133) aufweist, wobei das erste Element (131) des Wärmeschilds (130) in Bezug auf das zweite Element (133) beweglich ist und das erste Element (131) und das zweite Element (133) so angeordnet sind, daß sie zwischen sich lichte Abstände (135A, 135B) definieren, deren Abmessungen in Abhängigkeit von deren relativen Positionen einstellbar sind.

5. Verdampfungsvorrichtung (10; 100) gemäß einem der Ansprüche 1 bis 4, die Steuermittel aufweist, die dazu ausgelegt sind, einen in Bezug auf den Körper (22; 122) des Tiegels (20; 120) beweglichen Teil (31; 131) des Wärmeschilds (30; 130) zu betätigen.

6. Verdampfungsvorrichtung (200) gemäß einem der Ansprüche 1 bis 5, bei der der Boden (221) des Tiegels (220) in Bezug auf den Körper (222) des Tiegels (220) translatorisch beweglich angebracht ist.

7. Verdampfungsvorrichtung (200) gemäß Anspruch 6, die zusätzliche Steuermittel aufweist, die dazu ausgelegt sind, den Boden (221) des Tiegels (220) zu betätigen, um den Boden (221) entlang des Körpers (222) des Tiegels (220) zu versetzen.

8. Vakuumbeschichtungsgerät (1), das eine Verdampfungsvorrichtung (10; 100; 200) gemäß einem der Ansprüche 1 bis 7 aufweist.

## Claims

1. Evaporation device (10) for a vacuum deposition apparatus (1) including:
- a crucible (20) intended to contain a material to be evaporated (24) and comprising a bottom (21), a body (22) and an opening (23), and
- heating means (12) surrounding at least partially the body (22) of the crucible (20),
the evaporation device (10) being intended to be placed inside a vacuum chamber (2) of the vacuum deposition apparatus (1) in which the pressure is lower than 10⁻³ mbar, and being **characterized in that** it also includes at least one thermal shield (30) interposed between the body (22) of the crucible (20) and the heating means (12), the thermal shield (30) comprising at least one element (31) that is movable with respect to the crucible (20) and that is designed in such a manner that the quantity of heat (Q) received by the body (22) of the crucible (20) at a considered point of this body (22) is conform, at a given instant of time, to a non-constant function of the distance (D) between the considered point and the bottom (21) of the crucible (20), this function being adjustable as regards at least one degree of movability of the first element (31) of the thermal shield (30) with respect to the crucible (20).

2. Evaporation device (10) according to claim 1, wherein the first element (31) of the thermal shield (30) is mounted movable in translation with respect to the crucible (20).

3. Evaporation device (10) according to one of claims 1 and 2, wherein the first element (31) of the thermal shield (30) is mounted movable in rotation with respect to the crucible (20).

4. Evaporation device (100) according to one of claims 1 to 3, wherein the thermal shield (130) comprises at least one second element (133), the first element (131) of the thermal shield (130) being movable with respect to this second element (133), and the first element (131) and the second element (133) being arranged so as to define between each other apertures (135A, 135B) whose size is adjustable as a function of their relative positions.

5. Evaporation device (10;100) according to one of claims 1 to 4, comprising control means adapted to actuate a mobile part (31; 131) of the thermal shield (30; 130) with respect to the body (22; 122) of the crucible (20; 120).

6. Evaporation device (200) according to one of claims 1 to 5, wherein the bottom (221) of the crucible (220) is mounted movable in translation with respect to the body (222) of the crucible (220).

7. Evaporation device (200) according to claim 6, comprising additional control means adapted to actuate the bottom (221) of the crucible (220) to move said bottom (221) along the body (222à) of the crucible (220).

8. Vacuum deposition apparatus (1) comprising an evaporation device (10; 100; 200) according to one of claims 1 to 7.
